# EUROPEAN PATENT APPLICATION

(11) **EP 4 647 801 A1**
(43) Date of publication of application: **12.11.2025**
(21) Application number: 24174992.8
(22) Date of filing: 08.05.2024
(51) Int. Cl.: G01S 7/02, G06F 16/901, G06F 30/20

(54) **RF LIBRARY GENERATION**

(71) Applicant: Helsing GmbH, 81671 Munich (DE)
(72) Inventor: MATTWICH, Frederik, 81671 Munich (DE); KOHLER, Michael, 81671 Munich (DE); KRAH, Moritz, 81671 Munich (DE)
(74) Representative: Rummler, Felix

(57) **Abstract**

A method of determining a signal lookup table for RF signals, the method comprising: receiving, by a sensor included in a signal processing device, a plurality of predetermined radio frequency (RF) input signals generable by one or more RF emitters; receiving, from the signal processing device, output data items indicative of the output signals generated by the signal processing device in response to detecting the input signals; and for each input signal, storing one or more input signal characteristics related to the input signal and an output data item corresponding to the input signal as an entry in a lookup table (LUT).

## Description

### Technical Field

The present disclosure relates to systems, methods, and computer program products for processing RF signals, in particular determining and processing a signal lookup table for RF signals.

The method is applicable in the field of Electronic Warfare, in particular Electronic Warfare Support.

### Background

A frequent problem in Electronic Warfare is the creation and maintenance of ESM emitter libraries. Such libraries are applicable, for example, for recognizing known emitters.

A known solution is the highly manual and knowledge intensive translation of a signal description to a ESM System specific library entry. This has to be done for each ESM System individually, as each ESM System perceives and processes the signals differently.

There is a need for systems and methods that overcome these shortcomings.

### Summary

The present disclosure relates to systems, methods, and computer program products for determining signal lookup tables and for determining characteristics of RF signals.

A first aspect of the present disclosure relates to a method of determining a signal lookup table for RF signals. The method comprises the following steps:
- receiving, by a sensor included in a signal processing device, a plurality of predetermined radio frequency (RF) input signals generable by one or more RF emitters;
- receiving, from the signal processing device, output data items indicative of the output signals generated by the signal processing device in response to detecting the input signals; and
- for each output data item, storing one or more input signal characteristics related to the input signal and the output data item corresponding to the input signal as an entry in a lookup table (LUT).

The input signals, sensor and/or signal processing device may be simulated. One or more output data items may be generated in response to the detection of a single input signal. Each output data item is entered in the LUT. A plurality of data output items may be generated by the signal processing device based on the same input signal.

The method has the effect that the accuracy of the LUT may be increased by predetermining many or all RF input signals that are likely to be received in a realistic environment. In particular, since the output data items are determined by the signal processing device, they indicate the output of the signal processing device. They are generated by systematic use of the device, which does not require any knowledge of its inner workings and/or interpretation of its functions. The LUT may be generated quickly by processing a variety of RF input signals by the signal processing device. The method may comprise a computer-implemented method.

A second aspect of the present disclosure relates to a further method of determining a signal lookup table for RF signals, which may be combined with the method of the first aspect or executed separately. The method may comprise the following steps:
- determining, preferably by searching, one or more subsets of entries that meet a, preferably predetermined, similarity criterion;
- generating a combined entry from each of the subsets, in particular wherein each combined entry includes a generalised output data item that is indicative of the similarity criterion and/or represents the output data items that meet the similarity criterion; and
- storing the combined entry in the LUT.

The technical effect of storing one or more a combined entries in the LUT is that any one of the output data items can be related to the characteristics. This means that the LUT is usable to consistently detect the emitter type and/or emitter mode, This allows an optimised and faster generation and usage of the LUT..

The output data item may comprise any representation of the output signals, in particular the respective output signal itself. However, the output data item may comprise a result of a standardised, predetermined postprocessing step of the output signal. A generalised output data item may comprise one or more intervals of values ranging from a minimum value to a maximum value representing the range defined by the similarity criterion.

In some embodiments, e.g. if the emitter comprises a frequency agile emitter, the detection system may generate a plurality of output signals upon which a plurality of output data items may be based. In this case, a plurality of entries may be generated that comprise different output signals but identical characteristics...

Generating a combined entry from the similar entries allows relating a plurality of output data items to one and the same emitter and/or emitter mode. This allows an optimised and faster generation and usage of the LUT.

The present method is directed to determine and/or update an emitter lookup table (LUT). Subsequently, the LUT is applicable in an application method comprising receiving a test output data item and using it as a key to look up the stored characteristics.

In another embodiment, the similarity criterion is indicative of a similarity of respective output data items of a plurality of entries. The similarity may include a similarity of values, value types, and/or value ranges of the output data items, or a logical structure and/or abstractions thereof. A similarity may generally refer to numbers and/or values being identical, substantially identical, and/or a difference thereof being below a predetermined similarity threshold. In an illustrative example, two output data items indicative of pulse repetition intervals (PRI), pulse durations, and frequencies may be considered similar based on the PRIs and the pulse durations of the two output data items being equal and the frequencies being random for both output data items.

In a further embodiment, the similarity criterion includes one or more of:
- identity of one or more characteristics, and
- one or more of the characteristics being comprised in a predetermined range.

This allows combining the entries based on the characteristics. This has the advantage that the need for a manual translation from the characteristics of the RF input signal to the result of its processing by the signal processing device is eliminated. Instead, the combination of the entries is based on knowledge about the input RF signal, which may be part of the setup of the simulated or real-world generation of the output signal.

The combined entry may comprise data indicative of the similarity criterion.

For example, in response to determining that a plurality of entries meets a predetermined similarity criterion. In an example, the amplitude, pulse duration, and pulse repetition interval are all equal, but the frequencies are different. The matching entries are combined into a combined entry.

In a further embodiment, the similarity criterion is determined based on a similarity of all entries in the LUT.. A similarity may generally refer to numbers and/or values being identical, substantially identical, and/or a difference thereof being below a predetermined similarity threshold.

In another embodiment, the method comprises determining a plurality of subsets, each according to a respective similarity criterion.

The method may further comprise removing each entry from all subsets that meets more than one similarity criterion, before generating the combined entries.

Therefore, the subsets might be pairwise disjunct. This allows reducing ambiguities.

In yet another embodiment, the method further comprises removing the single entries that were combined.

In another embodiment, the method further comprises removing one or more of the entries from the LUT before determining the characteristics and/or the subset.

This means that some of the emitter entries can be removed to make the LUT specific to a particular task at hand, such as a mission.

In another embodiment, the method further comprises the following steps:
- determining one or more of the RF input signals by simulating one or more RF input signals, preferably based on the characteristics and/or by simulating one or more RF emitters emitting the one or more RF input signals; and/or
- determining one or more of the outputs of the signal processing device by simulating the signal processing device and/or one or more output signals of the signal processing device.

The benefit of simulating is that a multitude of RF emitters can be simulated faster and with less operational effort.

For example, a large number of different operation modes of an emitter can be simulated and the corresponding output data items can be determined. It is preferred to combine the output data items into one or more combined entries by defining the similarity criterion as identity of an identifier of the emitter type and/or emitter mode. The LUT is then applicable to determine the emitter type and or emitter mode from a slightly different output data item.

The simulation may take into account any distortion of the input signal that may occur due to atmospheric conditions and/or other effects that may be simulated. At the same time, it is preferred to use the predetermined characteristics to determine the similarity criterion. This has the effect that the simulated distortions are taken into account.

A third aspect of the present disclosure relates to a method of determining a characteristic of RF signal. The method comprising the following steps:
- receiving a test data item indicative of signals generated by a signal processing device in response to detecting an RF signal; and
- querying a lookup table based on the data item to determine characteristics of the unknown emitter.

The lookup table may comprise entries comprising input signal characteristics and corresponding output data items. The lookup table is preferably generable or generated by the method of the first aspect of the present disclosure.

The lookup table might indicate ambiguities in determining a matching entry of the lookup table if the entry comprises the test data item and/or a data item similar to the test data item. The ambiguity may be resolved by application of a predetermined priority rule. A priority rule may include ordering the emitter types, emitter modes, and/or emitter type/mode pairs in a predetermined priority order, and in case of ambiguity. Application of the priority rule may include matching the emitter type, mode, or type/mode pair ranking highest in the priority order.

In embodiments related to the first and/or second aspect, the input signal characteristics comprise one or more of a type and/or a mode and/or other metadata related to the or an emitter. The signal characteristics may comprise the signal itself and/or an abstract representation of signal properties, such as minimum or maximum frequencies. In embodiments related to the first, second and/or third aspect, the method further comprises determining the output data items and/or the test data item by discretizing the output signal on a predetermined scale.

Discretizing preferably includes replacing one or more values of the output signal by an interval encompassing the respective value. Application of the LUT then leads to a binning effect, wherein a value is matched if it is within the interval. This allows generating some overlap, i.e., if there is only a minimal deviation between the RF signal from the signal processing device in the test scenario compared to the LUT generation scenario, the signals will match.

A fourth aspect of the present disclosure relates to a system comprising one or more processors and one or more storage devices and preferably the signal processing device, wherein the system is configured to perform the computer-implemented method of the first, second and/or third aspect of the present disclosure.

A fifth aspect of the present disclosure relates to a computer program product for loading into a memory of the system. The computer program comprises instructions, that, when executed by a processor of the system, cause the system to execute a method of the first, second and/or third aspect of the present disclosure.

In an embodiment, a non-transitory computer-readable storage medium is provided that stores instructions executable by one or more processors. The instructions comprise any of the steps of a method of the first and/or second aspect of the present disclosure.

A sixth aspect of the present disclosure relates to a computer program product comprising a lookup table obtainable by the method of the first and/or second aspect of the present disclosure. In an embodiment, a non-transitory computer-readable storage medium is provided that stores the lookup table.

All properties and embodiments of the different aspects are mutually applicable to the other aspects.

### Brief description of the drawings

The features, objects, and advantages of the present disclosure will become more apparent from the detailed description set forth below when taken in conjunction with the drawings in which like reference numerals refer to similar elements.
- Fig. 1 shows a flow chart depicting a method 100;
- Fig. 2 shows a block diagram depicting a scenario 200 comprising systems and devices;
- Fig. 3 shows a block diagram depicting data structures;
- Fig. 4 shows a flow chart depicting a method 400;
- Fig. 5 shows a schematic graph depicting characteristics of signals in a first example; and
- Fig. 6 shows a schematic graph depicting characteristics of signals in a second example.

### Detailed description of the preferred embodiments

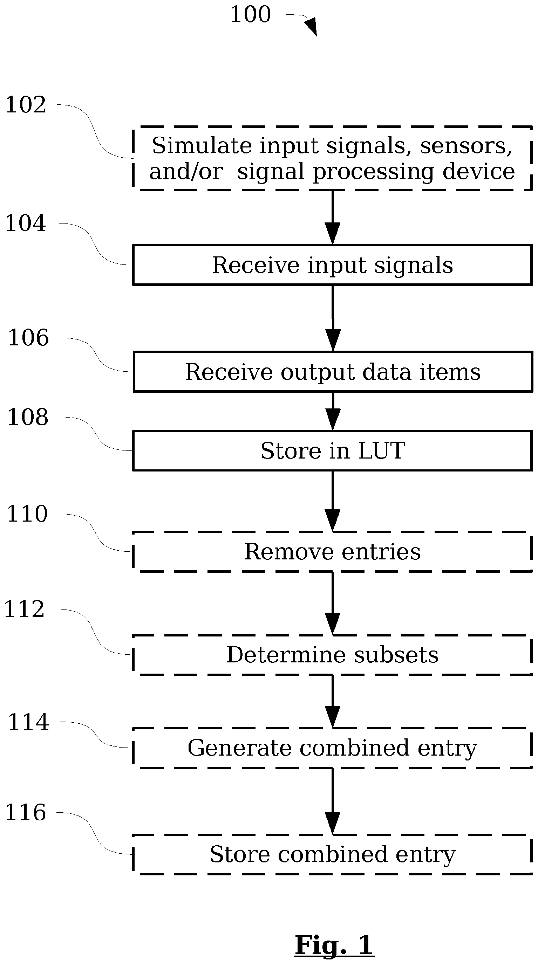

Figure 1 shows a flow chart depicting a method 100. Method 100 has the purpose of determining a signal lookup table for RF signals. Steps of the method 100 may be executed by the system 206.

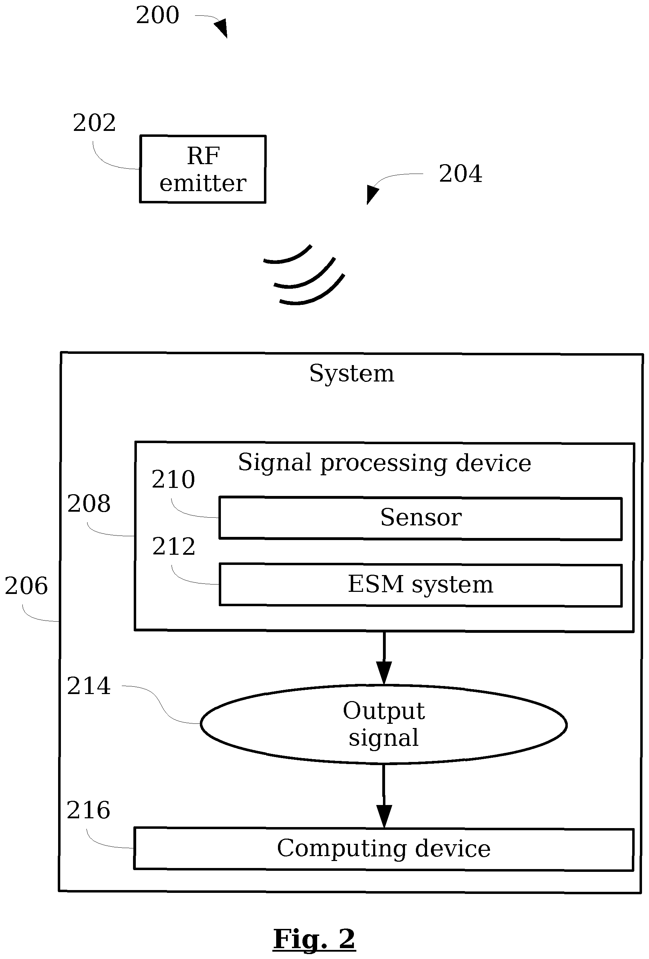

In the example shown in Fig. 1, method 100 begins by the optional step simulating, 102, input signals, sensors, and/or the signal processing device. The simulation is preferably set up as a simulation of a scenario as shown in Figure 2. Alternatively, step 102 may include determining a pair of an emitter type and an emitter mode as characteristics and simulating an input signal based on the characteristics. Generating the LUT using a simulation has the advantage that a larger variety of emitter characteristics, in particular emitter types, can be used in order to obtain a larger lookup table, faster and with relatively low operational effort. However, the determination of the input signal may comprise, in addition to or as an alternative to the simulation, receiving one or more real-world input signals, such as input signals recorded from real-world emitters in the past.

At step 104, a sensor receives one or more predetermined RF input signals. The input signals are generable by one or more RF emitters.

At step 106, output data items are received from the signal processing device 208. The output data items 304 are indicative of the output signals 214 generated by the signal processing device 208 in response to detecting the input signals.

At step 108, one or more input signal characteristics 306 related to the input signal and an output data item 304 corresponding to the input signal are stored as an entry 302 in a lookup table (LUT). That is, the output data item 304 is stored so that the resulting LUT may be searched in order to find the output data item. At least one input signal characteristic 306 is stored as part of the same entry 302, such that once the output data item is found, the at least one input signal characteristic 308 associated to the output data item can be retrieved from the LUT.

At optional step 110, the one or more entries are removed from the LUT. It is preferred to first create a LUT comprising a large number of emitters, and to generate a smaller LUT by removing some entries from the LUT that relate to emitters that are unlikely to be relevant for a particular purpose, e.g., a particular mission.

At optional step 112, one or more subsets of entries are determined that meet a similarity criterion. It is preferred that the similarity criterion is predetermined. It is preferred to determine the subsets by preferably by searching. For example, the similarity criterion may comprise a criterion that one or more values included in the output data item differ from one another at most by a predetermined similarity threshold. It is preferred to include into the subsets only entries that meet the similarity criterion of the output data items, and which include similar or identical characteristics. This leads to combining only entries related to identical or similar emitter type / emitter mode pairs. However, this need not mean that all entries with identical or similar emitter type / emitter mode pairs are combined. Even after combination, a plurality of entries may remain if differences between them are above the similarity threshold applied.

At optional step 114, a combined entry is generated from each of the subsets. It is preferred that each combined entry includes a generalised output data item that is indicative of the similarity criterion. For example, if an agile emitter has a fixed frequency mode and a frequency hopping mode, the similarity criterion may indicate that all parameters other than the frequency (for example pulse width, pulse repetition interval) are the same. In this example, the generalised output data item should comprise data indicative of a pulse train wherein the frequency may be anywhere in the frequency range of the emitter, and the other parameters are the same parameters as specified. The corresponding characteristics to be stored in the same entry comprise the other parameters but not the frequency. Alternatively, or additionally, each combined entry represents the output data items 304 that meet the similarity criterion.

At optional step 116, the combined entry (302) is stored in the LUT.

The method is applicable to generate a LUT that is adapted to the signal processing device. Applications include, in particular, the following:
As a first exemplary application, executing steps 102 to 108 allows generation of a LUT specific to the signal processing device. The entries of the LUT comprise output of the signal processing device.

As a second exemplary application, executing steps 102 to 116 allows an even better adaptation to a signal processing device. This is particularly relevant where the signal processing device outputs a plurality of output signals for the same input signal.

The first and the second exemplary applications allow determination of a very large LUT comprising entries related to all known emitters.

Executing steps 110 to 116, based on a predetermined LUT, allows adapting the LUT both to the signal processing device and a mission scenario in which only a part of the known emitters is expected to be present. The remaining emitters may be removed, and the generalised entries for the emitters expected to be present can encompass a broader parameter range as ambiguities with the removed emitters need not be avoided.

Figure 2 shows a block diagram depicting a scenario 200 comprising systems and devices. In an example, the scenario 200 relates to a setup of a simulation. The simulation includes a virtual emitter 202 comprising an antenna having specific antenna characteristics. The antenna is simulated to emit an RF input signal 204, having properties based on emitter properties. The emitter may comprise a radar system, such as an agile radar.

It is preferred to set up the simulation depending on predetermined characteristics, determine the output data item by the simulation, and store the predetermined characteristics in an entry in the lookup table. In this case, one entry may relate to one simulation. The characteristics can be varied to cover a parameter range in predetermined discrete steps, such as the input signal having a variety of frequencies. In this case, each variation along the parameter range is preferably chosen for a respective simulation, and the resulting entry in the lookup table is derived from that simulation. Doing so has the advantage that simulations can be run faster than real-world experiments, so that a larger number of simulations can be run an a larger number of entries for the lookup table can be created.

The RF input signal 204 may comprise any RF signal. In some cases, RF input signal 204 is a radar signal of an agile radar that has properties, e.g., pulse width, pulse duration, and frequency, that change systematically or stochastically.

The simulation may further include a system 206, a signal processing device 208, and the relative spatial orientation and distance of the emitter 202 and the signal processing device 206.

The simulation may further include an effect of conditions of a medium in which the signal 204 propagates, as well as reflection and/or scattering of the signal 204 on surfaces and/or interfaces. The RF emitter 202 and the system 206 may be each or both be land-based, or comprised in aircraft, ships or submarines. According to the setting, atmospheric, geographic and/or hydrographic conditions may be relevant.

System 206 may comprise a signal processing device 208. The signal processing device 208 comprises a sensor 210, preferably an antenna, operable to receive the input signal 204. The signal processing device may further include a radar receiver and/or an Electromagnetic Support Measure (ESM) system. Signal processing device 208 is configured to generate an output signal 214 indicative of the input signal 204.

Output signal 214 may therefore contain information about characteristics of the RF emitter 202, the conditions of the medium in which the signal 204 propagated, and the specifics of system 206, in particular the sensor 210 and the processing by the signal processing device 208. Therefore, its relation to RF signal 204 may be non-trivial. Output signal 214 may comprise a Pulse Data Word (PDW), or any other data format suitable for describing an RF signal. In particular, if signal 204 comprises a signal of an agile radar, then the output signal 214 may be composed of a plurality of tracks, each of which is preferably described by a pulse data word. For example, if input signal 204 comprises random frequency jumps, signal processing device 208 may erroneously identify RF emitter 202 as a plurality of emitters, each at a different frequency. In this case, output signal may comprise a plurality of tracks, each for a frequency. In this case, each track, or data based on each track, can be included in one output data item. In this case, the signal processing device may output a plurality of output data items, and one entry may be stored in the LUT for each of the output data items.

Computing device 216 is configured to receive the output signal 214. Computing device preferably determines one or more output data items indicative of the output signals 214. The output data items may be identical to the output signals 214. The output data items may comprise a discretized or otherwise modified derivative of the output signal 214. In embodiments, the output data item 304 comprises representation obtainable by processing the output signal 214 by a machine learning algorithm, which may be executed by computing device 216.

In different embodiments, the scenario 200 is a real-world scenario in which an emitter and a system 206 are operated. It is, however, preferred to simulate the devices. This allows for easier and quicker amendments to the system 206 or parts thereof.

The RF input signal may comprise a historic recording of a real-world signal, or a synthetic signal.

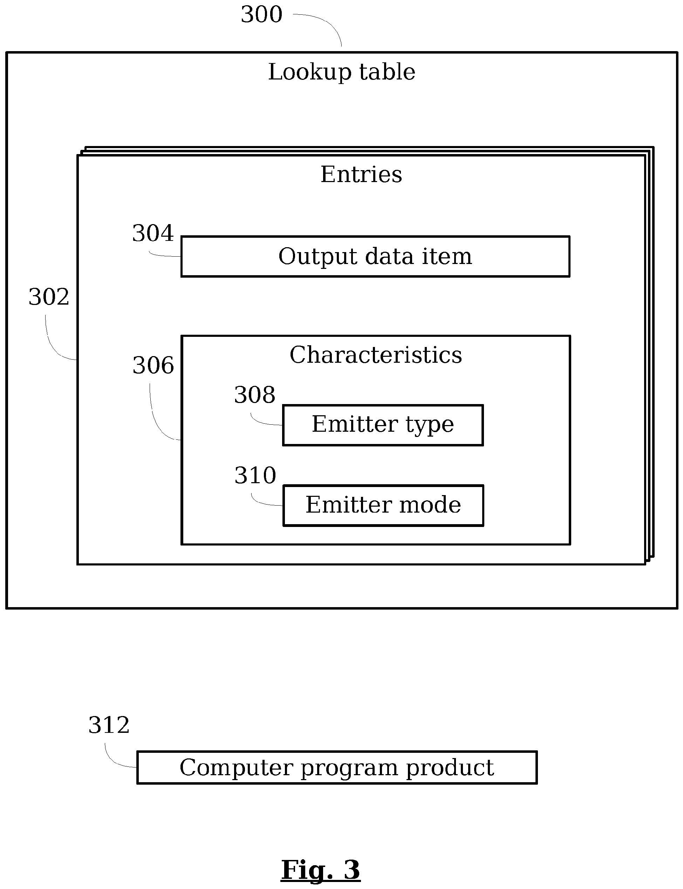

Figure 3 shows a block diagram depicting data structures. Lookup table 300 comprises a plurality of entries 302. Each entry comprises an output data item 304, which is derived from the output of the data processing device and therefore contains information on how the data processing device acts on the RF signal.. The output data item 304 may comprise a single output signal generated by the signal processing device 208. The output data item may comprise a generalized output data item in which one or more parameters are generalized, e.g., by replacing a specific value by a range. Generalized output data items may have been generated by step 114 of method 100. The output data item 304 may be identical to the output signal 214 of the signal processing device, or subject to a standardised postprocessing step.

The entry 302 further includes characteristics 306, which are independent of the signal processing device 208. They relate to properties of the system alone. They may comprise an emitter type 308, and/or an emitter mode 310.

An entry 302 of the LUT includes an output data item 304 and at least one characteristic of the input signal, e.g. emitter number 1 in mode A. The entries of the LUT may be grouped such that a resulting generalised entry includes a generalised output data item and the same at least one characteristic of the input signal (e.g. emitter 1 in mode A). The generalised output data item may represent all of those output data items that were associated with said at least one characteristic of the input signal (e.g. emitter 1 in mode A) and that shared a similarity. The LUT may be applicable as an emitter library. It may be specific to the signal processing device 208, e.g., to the ESM system 212.

The computer program product 312may be run on system 206 and may cause system 206 to execute step of any disclosed method.

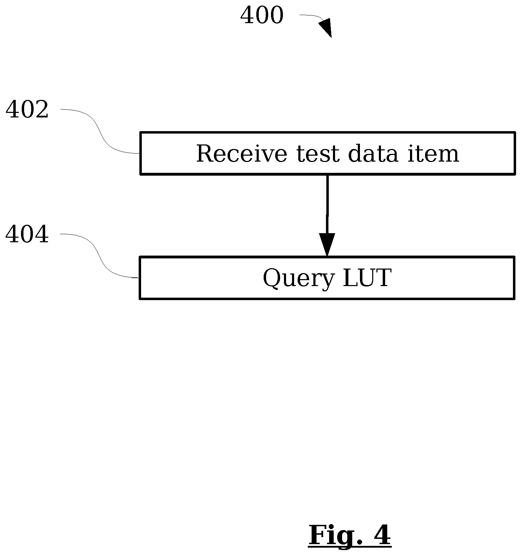

Figure 4 shows a flow chart depicting a method 400 of determining a characteristic of an RF signal. Method 400 begins by receiving a test data item. The test data item may be similar in format to the output data item and also comprise one or more tracks. In response, a LUT is queried to determine the corresponding characteristics. The LUT may be a LUT determined by method 100.

The lookup table may be used to identify an emitter and/or any characteristics of the emitter, such as a mode of the emitter. if an identical RF input signal is received by the signal processing device in the future. In this case, the signal processing device will generate the same output signal, such that the same output data can be determined. The output data may be used, e.g., as a search key, to retrieve the corresponding characteristics from the lookup table.

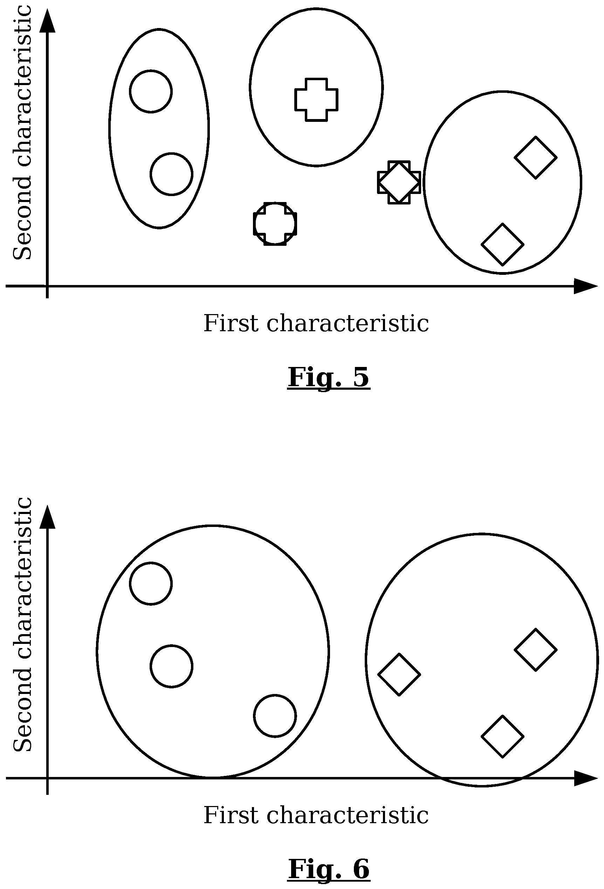

Figure 5 shows a schematic graph depicting characteristics of signals in a first example.

Characteristics of RF signals of a first emitter are depicted as positions of circles.

Here, only two characteristics are shown for simplicity. Characteristics may comprise pulse width and pulse frequency. In the present example, there are three RF signals originating from the same emitter. They differ because the first emitter is an agile radar that changes its characteristics over time.

This is a simplified example. In practice, there is a much larger number of signals in a higher-dimensional parameter space.

Figure 5 also shows three signals from a second emitter (+ signs) and three signals for a third emitter (rhombi). The above applies mutatis mutandis to the second and third emitter.

There are two cases where the characteristics are the same for two different emitters, i.e., they overlap. In these cases, there is an ambiguity and the emitters are not trivially identified. Therefore, the generalised output data item as determined in method 100 may encompass only the unambiguous sets of characteristics (shown by circles). In embodiments, the ambiguity may be resolved by application of a predetermined priority rule, i.e. the emitter types, emitter modes, and/or emitter type/mode pairs may be ordered in a predetermined priority order, and in case of ambiguity, the emitter type, mode, or type/mode pair ranking highest in the priority order is detected.

In an illustrative example, each emitter is an agile radar, and detection of a set of characteristics where the parameter spaces of emitters overlap leads to an ambiguous result, i.e. it is impossible to know from the output of the signal processing device from which emitter the signal originates.. Therefore, the generalised output data items are delimited against the ambiguous cases. In these cases, the use of the lookup table yields no result so that the output of confusing results is avoided.

Figure 6 shows a schematic graph depicting characteristics of signals in a second example. It is identical to the graph in Figure 5, except that all signals related to the second emitter have been removed. In this case, the generalised output data items related to the first and third emitters can be larger and encompass also the cases which were ambiguous in the first example of Figure 5.

In the illustrative example, removal of an emitter from the lookup table may be done by receiving an input, such as a user input, indicating that the emitter is not relevant. For example, if it is known that a certain type of radar is not used on a particular theatre of operations, the emitter type may be removed. In this case, the determination of similar subsets (steps 112-116 of method 100) is executed on the lookup table after removal of the irrelevant radar. In this case, the generalised output data items for the first and third radars cover larger parameter spaces (shown as circles).

### Reference signs

- 100: Method of determining a signal lookup table for RF signals
- 102-116: Steps of method 100
- 200: Scenario
- 202: RF emitter
- 204: Input signal
- 206: System
- 208: Signal processing device
- 210: Sensor
- 212: ESM system
- 214: Output signal
- 216: Computing device
- 300: Lookup table
- 302: Entries
- 304: Output data item
- 306: Characteristics
- 308: Emitter type
- 310: Emitter mode
- 312: Computer program product
- 400: Method of determining a characteristic of an RF signal
- 402, 404: Steps of method 400

## Claims

1. A method (100) of determining a signal lookup table for RF signals, the method comprising:
receiving (104), by a sensor (210) included in a signal processing device (208), a plurality of predetermined radio frequency, RF, input signals (204, 310) generable by one or more RF emitters (202);
receiving (106), from the signal processing device (208), output data items (304) indicative of the output signals (214) generated by the signal processing device (208) in response to detecting the input signals (204, 310); and
for each output data item, storing (108) one or more input signal characteristics (306) related to the input signal and the output data item (304) corresponding to the input signal as an entry (302) in a lookup table, LUT.

2. A method of determining a signal lookup table for RF signals, the method comprising:
determining, preferably by executing the steps of claim 1, a lookup table, LUT, comprising one or more entries (302), each of which comprises one or more input signal characteristics (306) related to an input signal and an output data item (304) corresponding to the input signal, wherein the LUT is generable by the steps of claim 1;
determining (112), preferably by searching, one or more subsets of entries that meet a, preferably predetermined, similarity criterion;
generating (114) a combined entry (302) from each of the subsets, in particular wherein each combined entry (302) includes a generalised output data item that is indicative of the similarity criterion and/or represents the output data items (304) that meet the similarity criterion; and
storing (116) the combined entry (302) in the LUT.

3. The method of claim 2,
wherein the similarity criterion is indicative of a similarity of respective output data items of a plurality of entries.

4. The method of any of claims 2-3, wherein the subsets of entries all include the same or similar characteristics.

5. The method of any of claims 2-4, wherein the similarity criterion is determined based on a similarity of all entries in the LUT.

6. The method of any of the preceding claims,
comprising determining a plurality of subsets, each according to a respective similarity criterion; and
further comprising removing each entry from all subsets that meets more than one similarity criterion, before generating the combined entries.

7. The method of any of the preceding claims, further comprising removing the single entries that were combined.

8. The method of any of the preceding claims, further comprising:
removing (110) one or more of the entries from the LUT before determining the characteristics and/or the subset.

9. The method of any of the preceding claims, further comprising:
determining one or more of the RF input signals (204, 310) by simulating (102) one or more RF input signals (204, 310), preferably based on the characteristics, and/or by simulating one or more RF emitters emitting the one or more RF input signals (204, 310); and/or
determining one or more of the outputs of the signal processing device (208) by simulating the signal processing device (208) and/or one or more output signals of the signal processing device (208).

10. A method (400) of determining a characteristic of an RF signal, the method comprising:
receiving (402) a test data item indicative of signals generated by a signal processing device (208) in response to detecting an RF signal; and
querying (404) a lookup table based on the data item to determine characteristics of the unknown emitter,
wherein the lookup table comprises entries comprising input signal characteristics and
corresponding output data items (304) and is preferably generable or generated by the method of any of claims 1-6, and
wherein querying the lookup table comprises determining a matching entry of the lookup table if the entry comprises the test data item or a data item similar to the test data item.

11. The method of any of the preceding claims, wherein the input signal characteristics (302) comprise a type (308) and/or a mode (310) and/or other metadata related to the or an emitter.

12. The method of any of the preceding claims, further comprising:
determining the output data items (304) and/or the test data item by discretizing the output signal (214) on a predetermined scale.

13. A system comprising one or more processors and one or more storage devices and preferably the signal processing device, wherein the system is configured to perform the computer-implemented method of any one of claims 1-12.

14. A computer program product (312) for loading into a memory of a computer, comprising instructions, that, when executed by a processor of the computer, cause the computer to execute a computer-implemented method of any of claims 1-12.

15. A computer program product comprising a LUT obtainable by the computer-implemented method of any of claims 1-9.
